# EUROPEAN PATENT SPECIFICATION

(11) **EP 1 456 681 B1**
(45) Date of publication and mention of the grant of the patent: **14.05.2008**
(21) Application number: 02790625.4
(22) Date of filing: 19.12.2002
(51) Int. Cl.: G01R 33/28

(54) **ELECTRONIC DEVICE FOR USE IN ELECTROMAGNETIC FIELDS OF AN MRI APPARATUS**
ELEKTRONISCHES GERÄT ZUR VERWENDUNG IN DEN ELEKTROMAGNETISCHEN FELDERN EINES MRI-GERÄTES
DISPOSITIF ELECTRONIQUE UTILISE DANS DES CHAMPS ELECTROMAGNETIQUES D'UN APPAREIL D'IRM

(30) Priority: 21.12.2001 EP 01205139
(43) Date of publication of application: 15.09.2004
(73) Proprietor: Koninklijke Philips Electronics N.V., 5621 BA Eindhoven (NL)
(72) Inventor: SINNEMA, Dirk, NL-5656 AA Eindhoven (NL); VRIJHEID, Johan, E., W., NL-5656 AA Eindhoven (NL)
(74) Representative: Wolfs, Marc Johannes Maria
(86) International application number: PCT/IB2002/005652
(87) International publication number: WO 2003/054568

(56) References cited:
- EP-A- 0 498 528
- EP-A- 0 968 733
- WO-A-91/19455
- US-A- 5 394 873

## Description

The invention relates to an electronic device for use in electromagnetic fields in or near the imaging volume of a medical MRI apparatus.

Such an electronic device is known from the published European patent application No. 1 105 966. The electronic device described therein is a television camera for monitoring a patient to be examined in the MRI apparatus. Apart from a television camera, many other electronic devices may be present in, or in the vicinity of, the imaging volume of the MRI apparatus, such as devices for transferring physiologic quantities such as pulse beat, blood pressure, temperature or ECG data, to devices for communication with the patient, such as audio communication, and to devices for illumination in the imaging volume of the MRI apparatus. Such devices all comprise electronic circuits which are capable of generating magnetic fields and/or emitting electromagnetic radiation during operation. As MRI apparatus are very sensitive to disturbing fields in the imaging volume of the apparatus, these disturbing fields cause artefacts in the MRI recordings to be made, which may lead to interpretation errors of said images. It is needless to say that this is undesirable in a medical application.

In international patent application WO 91/19455 an RF shield for use adjacent a portion of a patient's body during a magnetic resonance examination by magnetic resonance examination apparatus is described. In order to protect portions of the patient's body from the radio frequency energy used in MR equipment, the use of an RF shield in form of a sleeve is suggested. Alternatively, the RF shield shows the form of a mitt or boot in order to be placed over a patient's hand or foot.

It is an object of the invention to provide a device of the type mentioned in the opening paragraph, which does not exhibit interference with the MRI fields present in the imaging volume. To achieve this, the device in accordance with the invention is situated in an envelope provided with a protective layer which provides shielding against electromagnetic radiation from the device to the imaging volume, which envelope in addition does not constitute a source of disturbing eddy currents. The invention is based on the recognition that it must be possible to simultaneously apply a plurality of electronic devices in the imaging volume without disturbing the proper operation of the MRI apparatus, and that the measures taken for this purpose must not cause disturbances of a different kind. What also forms part of the recognition in accordance with the invention is that it is possible to manufacture a shielding envelope which does not only preclude electromagnetic leakage from the device but which also itself constitutes a negligible object of eddy currents.

The shielding layer is made of a material having a resistivity below 0.05 Ωm, the shielding layer has a thickness below 40 µm, and the total surface area of the shielding layer is less than 100 cm². In experiments it has been found that said values enable a good shielding to be achieved, while in addition this shielding does not become a source of disturbing eddy currents, which can be generated by the gradient fields of the MRI apparatus.

In an advantageous embodiment of the invention, the device is accommodated in a housing made of printed circuit board for electronic purposes. Said printed circuit board is readily available at a comparatively low price and has the important advantage that it is provided with a properly adhering layer of a conductive material, generally copper. In addition, by virtue of the nature of the original application of this board, it is arranged so as to be not adversely affected by soldered joints.

In another embodiment of the invention, the device is arranged to maintain a signal connection to an area outside the imaging volume via a high-frequency carrier wave. In this embodiment, signal-carrying conductors are not necessary as signal transfer is wireless, for example, via a 2.4 GHz carrier wave. By avoiding such signal-carrying conductors, the possibility is removed that such conductors could cause disturbing interference with the MRI fields. Equipment capable of establishing such a high-frequency carrier wave connection is commercially available. In yet another embodiment of the invention, the device is provided with a connection cable comprising mutually separated segments which are each shorter than a predetermined value, and wherein the separation between the segments is brought about by frequency-dependent separation elements forming a conductor for low-frequency currents and an insulator for radio-frequency alternating current. This embodiment is advantageous if the device has a comparatively long connection cable or if the connection cable must transfer a comparatively large (direct) current. In this case, a segmented connection cable does not electromagnetically disturb the electromagnetic fields of the MRI apparatus, and also the connection cable itself is not influenced by said fields. The segmented device cable must be composed of segments which, in any case, are each shorter than ¼ wavelength of the radio-frequency radiation generated in the MRI apparatus for producing the MRI image, but preferably these segments are shorter than 1/20 of said wavelength. The segments are separated from each other by self-inductance elements which, as is known, form a conductor for direct current and low-frequency signals and an insulator for high-frequency signals. In this case, low-frequency signals are to be taken to mean signals having a frequency up to for example 20 kHz, so that they also include audio signals, while high-frequency signals are to be taken to mean signals having a frequency above, for example, 20 MHz. In a typical MRI apparatus with a stationary field of for example 1.5 T, the radio-frequency signal has a frequency of approximately 64 MHz. The self-inductance elements thus form an insulator for the high frequencies and a conductor for the low frequencies. As a result, the cable thus segmented does not cause the antenna for emitting said high frequencies (referred to as RF body coil in an MRI apparatus) to become non-resonant, which would be the case if use were made of an unsegmented cable and hence RF excitation of the tissue to be imaged would no longer take place, so that MRI imaging would be impossible. Such segmented connection cables are known per se from said European patent application No. 1 105 966.

The invention will be described with reference to the drawings. In the drawings:
Fig. 1 diagrammatically shows the general construction of a magnetic resonance apparatus wherein the invention can be applied;
Fig. 2 is a more detailed view of the imaging volume of the magnetic resonance apparatus in accordance with Fig. 1;
Fig. 3 shows a working drawing of an envelope for an electronic device in accordance with the invention;
Fig. 4 is a cross-sectional view of the material from which the envelope in accordance with Fig. 3 is made.

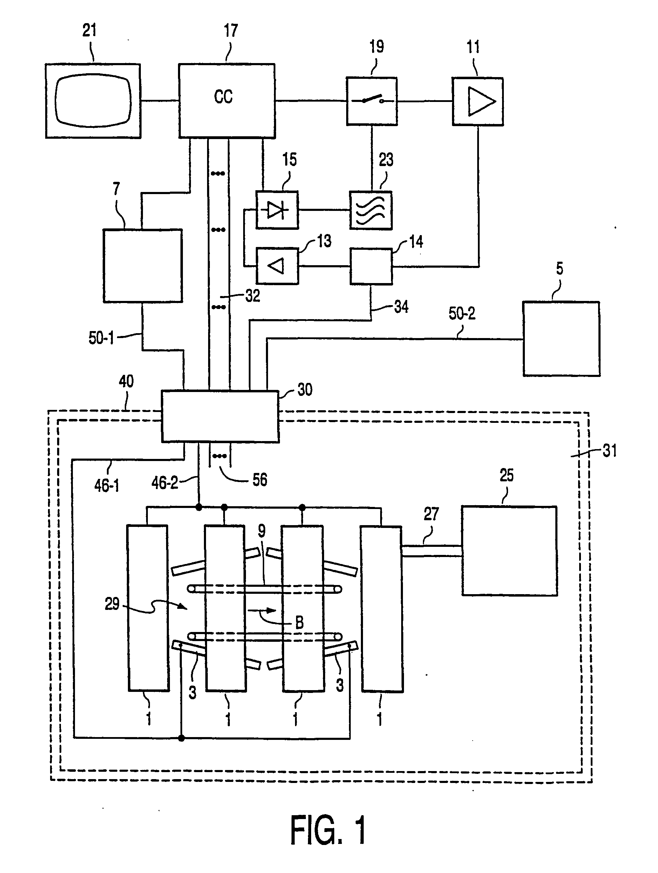

To illustrate the environment wherein the invention can be employed, a magnetic resonance apparatus (MRI apparatus) is diagrammatically shown in Fig. 1. This MRI apparatus comprises a first magnetic system 1 for generating a homogeneous stationary magnetic field B, a second magnetic system 3 for generating magnetic gradient fields, a power supply source 5 for the first magnetic system 1 and a power supply source 7 for the second magnetic system 3 for generating magnetic gradient fields, a power supply source 5 for the first magnetic system 1 and a power supply source 7 for the second magnetic system 3. A radio-frequency coil (RF coil) 9 is used to generate a radio-frequency magnetic alternating field and is connected, for this purpose, to an RF transmission device with a radio-frequency source 11. To detect electron spin resonance signals generated by the radio-frequency transmission field in an object to be examined (not shown), use can alternatively be made of the RF coil 9, which is connected, for this purpose, to an RF receiving device comprising a signal amplifier 13. The output of the signal amplifier 13 is connected to a detector circuit 15 that is connected to a central control device 17. Said central control device 17 further controls a modulator 19 for the RF source 11, the power supply source 7 and a monitor 21 for image display. A high-frequency oscillator 23 controls both the modulator 19 and the detector 15 processing measuring signals. The forward and backward RF signal traffic are separated from each other by a separation circuit 14. For cooling the magnetic coils of the first magnetic system 1 use is made of a cooling device 25 having coolant lines 27. The RF coil 9 arranged within the magnetic systems 1 and 3 encloses an imaging volume 29 which in the case of a device for producing images for medical applications is large enough to embrace a patient to be examined or a part of a patient to be examined, for example the head and the neck. In the imaging volume 29, a stationary magnetic field B, object-sections selecting gradient fields, and a spatially homogeneous RF alternating field can thus be generated. The RF coil 9 can combine the functions of transmitting coil and measuring coil. For both functions, use can alternatively be made of different coils, for example of surface coils as measuring coils. The assembly of coils 1, coil 9 and second magnetic system (gradient coils) 3 is surrounded by a Faraday cage 31 that provides shielding from RF fields.

A power supply line 50-1 extends from the power supply source 7 to the feedthrough device 30; also a power supply line 50-2 extends from the power supply source 5 to the feedthrough device 30. The central control device 17 and the various parts to be controlled (not shown) of the MRI apparatus within the Faraday cage 31 are interconnected by means of connection lines 32 which are connected via the feedthrough device 30 to said parts to be controlled. In addition, an RF connection line 34 is provided between the separation circuit 14 and the feedthrough device. Inside the Faraday cage, the power supply line 50-1 continues as connection line 46-1, and the power supply line 50-2 continues as connection line 46-2. The bundle of connection lines 32 is continued within the Faraday cage as the bundle of connection lines 56.

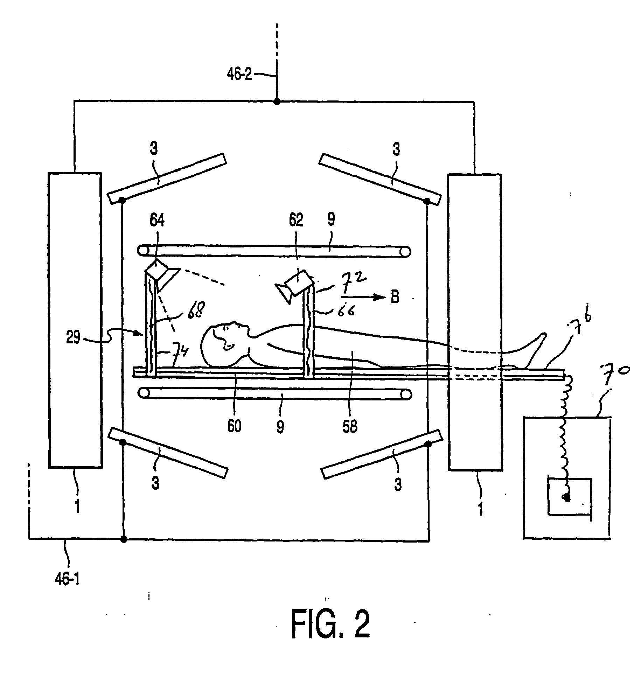

Fig. 2 shows the imaging volume of the MRI apparatus of Fig. 1 in greater detail. For the sake of clarity, only two coils of the first magnetic system 1 for generating a homogeneous stationary magnetic field B are shown. In the imaging volume 29, a patient 58 to be examined is placed on a patient carrier 60 in such a manner that sectional images of the head and the neck can be produced. Within the imaging volume 29, or in the direct vicinity thereof, electrical connection equipment for maintaining a connection with the patient to be examined is present, in this case a TV camera 62 and a lamp 64 for illuminating the field of view to be recorded by the camera. It is to be noted, however, that other electrical connection equipment can alternatively be provided in or near the imaging volume, such as sensors for recording blood pressure, heart beat or brain activity of the patient, or for carrying out bidirectional communication with the patient.

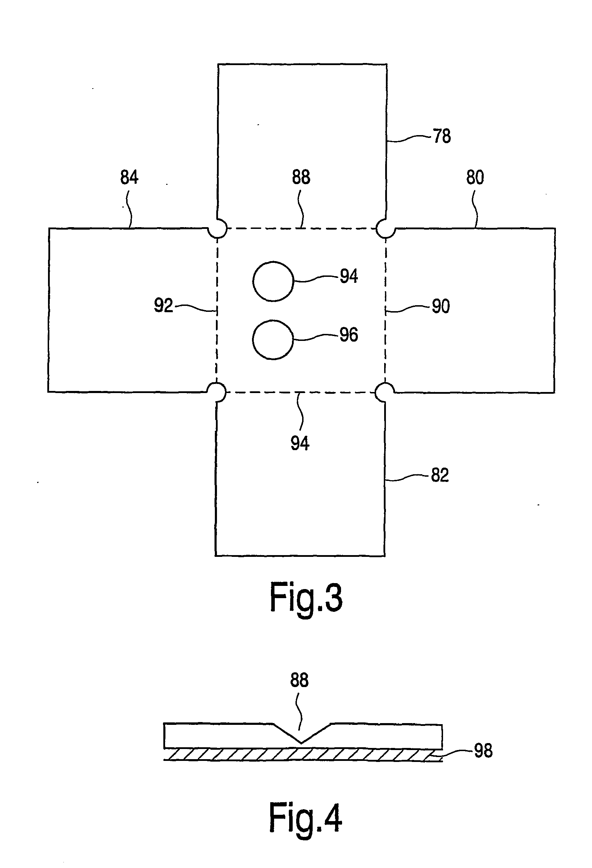

The TV camera 62 and the lamp 64 are supplied with power from supply apparatus 70 via a respective supply conductor 66 and 68. The two supply conductors 66 and 68 extend through the homogeneous magnetic field B and through the RF field generated by the coils 9. The present invention provides measures to preclude that the RF field generated by the coils 9 and/or the homogeneous magnetic field B are disturbed such that the quality of the sectional images to be produced by means of the MRI apparatus are adversely affected. The devices 62 and 64 can each be attached to the patient carrier 60 via a device carrier 72, 74, respectively, in a manner which will be described in greater detail with reference to Fig. 3. To supply power to these devices 62 and 64, said device carriers are each provided with a connection cable 66, 68, respectively, which extend through the preferably hollow device carriers. The connection cables electrically contact conductor strips in a groove 76 in the side face of the patient carrier 60, as will be described in greater detail with reference to Fig. 3. The conductor strips in groove 76 are connected to an interface unit 70 via a flexible, detachable cable. This interface unit may comprise a power source for feeding said devices, and it may also comprise filtering means for separating a possible low-frequency signal, such as an audio signal, from the DC power. Said measures for precluding disturbance of the MRI fields consist in that the connection cables 66 and 68 comprise mutually separated segments which are each shorter than a predetermined value, i.e. shorter than ¼ of the wavelength of the RF field and preferably shorter than 1/20 of said wavelength, and in which the separation between the segments is brought about by frequency-dependent separation elements forming a conductor for low-frequency currents and an insulator for radio-frequency alternating current. These frequency-dependent separation elements are preferably embodied so as to be bifilarly wound self-inductance elements. Said segments are embodied so as to be two twisted wires, as a result of which the current flowing through these wires generates an unnoticeable magnetic field outside the connection cable. Such connection cables are known per se from said European patent application No. 1 105 966.

Fig. 3 shows a working drawing of an envelope for an electronic device in accordance with the invention. For the starting material use is made of a printed circuit board such as customarily used as a support for electronic components. The PCB material in question is provided on one side with a copper layer having a thickness of 17 µm. If a cube-shaped envelope is desired, a surface as shown in the Figure is formed from the PCB material, i.e. a surface composed of five squares 78, 80, 82, 84 and 86. At the locations where the squares are interconnected, weakening grooves 88, 90, 92 and 94 are provided so that the material can be folded more readily into a cube. At the angular points of square 86, circular holes are drilled so as to provide space during folding. In square 86 two more holes 94 and 96 are formed enabling feedthroughs for power supply and signal transfer to be provided. After the plate material shown has been formed, it can be folded so as to obtain a cube which is open on one side. In this operation, the copper layer remains on the inside of the cube.

Fig. 4 is a cross-sectional view of the material from which the envelope in accordance with Fig. 3 is made. The material has an overall thickness of 0.6 mm, and groove 88 has a depth of 0.4 mm. After the open cube has been formed, a piece of PCB material the size of which is equal to that of the missing side is formed, and this piece of material can be provided with electronic components and soldered onto the open side. In this manner, a shielded envelope is obtained which, as shown in experiments, is capable of counteracting disturbance of the MRI fields in such a manner that no observable image disturbance occurs, provided the shielding layer is made of a material whose resistivity is below 0.05 Ωm, the layer has a thickness below 40 µm, and the total surface area of the shielding layer is less than 100 cm².

## Claims

1. An electronic device (62, 64) for use in electromagnetic fields in or near the imaging volume (29) of a medical MRI apparatus,
the device being situated in an envelope provided with a shielding layer (98),
the shielding layer (98) being made of a material having a resistivity below 0.05 Ωm, the shielding layer (98) having a thickness below 40 µm, and the shielding layer (98) having a total surface area of less than 100 cm2, such that the shielding layer (98) provides shielding against electromagnetic radiation from the device to the imaging volume (29), and in addition does not constitute a source of disturbing eddy currents generated by the gradient fields of the MRI apparatus.

2. An electronic device as claimed in claim 1, wherein the device (62, 64) is accommodated in a housing made of printed circuit board for electronic purposes.

3. An electronic device as claimed in any one of the preceding claims, wherein the device is arranged so as to maintain a signal connection to an area outside the imaging volume (29) via a high-frequency carrier wave.

4. An electronic device as claimed in any one of the preceding claims, which device is provided with a connection cable (66, 68) comprising mutually separated segments which are each shorter than a predetermined value, and wherein the separation between the segments is brought about by frequency-dependent separation elements forming a conductor for low-frequency currents and an insulator high frequency alternating current.

## Patentansprüche

1. Elektronische Einrichtung (62, 64) zum Einsatz in elektromagnetischen Feldern in oder nahe dem Bildgebungsvolumen (29) eines medizinischen MRI-Geräts,
wobei die Einrichtung in einer mit einer Abschirmschicht (98) versehenen Umhüllung liegt,
wobei die Abschirmschicht (98) aus einem Material hergestellt ist, das einen spezifischen Widerstand kleiner als 0,05 Ωm hat, wobei die Abschirmschicht eine Dicke kleiner als 40 µm hat und die Gesamtfläche der Abschirmschicht weniger als 100 cm² beträgt, sodass die Abschirmschicht (98) eine Abschirmung gegen elektromagnetische Strahlung aus der Einrichtung heraus zum Bildgebungsvolumen (29) hin verschafft und zusätzlich keine Quelle störender Wirbelströme bildet, die von den Gradientenfeldern des MRI-Gerätes erzeugt werden.

2. Elektronische Einrichtung nach Anspruch 1, wobei die Einrichtung (62, 64) in einem Gehäuse untergebracht ist, das aus Printplattenmaterial für elektronische Zwecke hergestellt ist.

3. Elektronische Einrichtung nach einem der vorhergehenden Ansprüche, wobei die Einrichtung ausgebildet ist, über eine hochfrequente Trägerwelle eine Signalverbindung zu einem Gebiet außerhalb des Bildgebungsvolumens (29) aufrechtzuerhalten.

4. Elektronische Einrichtung nach einem der vorhergehenden Ansprüche, welche Einrichtung mit einem Anschlusskabel (66, 68) versehen ist, das voneinander getrennte Segmente umfasst, die jeweils kürzer sind als ein zuvor bestimmter Wert, und wobei die Trennung zwischen den Segmenten mittel frequenzabhängiger Trennelemente zustande gebracht wird, die einen Leiter für niederfrequente Ströme und einen Isolator für hochfrequenten Wechselstrom bilden.

## Revendications

1. Dispositif électronique (62, 64) pour être utilisé dans des champs électromagnétiques à l'intérieur ou à proximité du volume d'imagerie (29) d'un appareil médical d'imagerie par résonance magnétique,
le dispositif étant situé dans une enveloppe qui est pourvue d'une couche de protection (98),
la couche de protection (98) étant fabriquée à partir d'un matériau ayant une résistivité qui est inférieure à 0,05 Ωm, la couche de protection (98) ayant une épaisseur qui est inférieure à 40 µm et la couche de protection (98) ayant une zone de surface totale qui est inférieure à 100 cm² de telle façon que la couche de protection (98) donne une protection contre le rayonnement électromagnétique en provenance du dispositif au volume d'imagerie (29) et en outre ne constitue pas de source de courants perturbateurs de Foucault qui sont générés par les champs de gradient de l'appareil MRI.

2. Dispositif électronique selon la revendication 1, dans lequel le dispositif (62, 64) est incorporé dans un boîtier qui est fabriqué à partir d'une carte de circuit imprimé à des fins électroniques.

3. Dispositif électronique selon l'une quelconque des revendications précédentes 1 à 2, dans lequel le dispositif est agencé de manière à maintenir une connexion de signal à une zone en dehors du volume d'imagerie (29) par le biais d'une onde porteuse à haute fréquence.

4. Dispositif électronique selon l'une quelconque des revendications précédentes 1 à 3, lequel dispositif est pourvu d'un câble de raccordement (66, 68) comprenant des segments mutuellement séparés dont chacun est plus court qu'une valeur prédéterminée et dans lequel la séparation entre les segments est provoquée par des éléments de séparation dépendant de la fréquence constituant un conducteur pour des courants de basse fréquence et un isolateur pour des courants alternatifs de haute fréquence.
